Europäisches Patentamt

European Patent Office

Office européen des brevets

(11) Numéro de publication: **0 246 135 B1**

(12) **FASCICULE DE BREVET EUROPEEN**

(45) Date de publication de fascicule du brevet:
**22.01.92**

(51) Int. Cl.⁵: **H03D 13/00**

(21) Numéro de dépôt: **87400989.7**

(22) Date de dépôt: **29.04.87**

(54) **Détécteur de phase et de fréquence, et son utilisation dans une boucle à verrouillage de phase.**

(30) Priorité: **13.05.86 FR 8606860**

(43) Date de publication de la demande:
**19.11.87 Bulletin 87/47**

(45) Mention de la délivrance du brevet:
**22.01.92 Bulletin 92/04**

(84) Etats contractants désignés:
**DE GB IT NL SE**

(56) Documents cités:
**FR-A- 2 162 602**
**GB-A- 1 462 408**
**US-A- 4 277 754**
**US-A- 4 500 852**

(73) Titulaire: **THOMSON-CSF**
**51, Esplanade du Général de Gaulle**
**F-92800 Puteaux(FR)**

(72) Inventeur: **Lazarus, Michel**
**THOMSON-CSF SCPI 19, avenue de Messine**
**F-75008 Paris(FR)**
Inventeur: **Frances, Michel**
**THOMSON-CSF SCPI 19, avenue de Messine**
**F-75008 Paris(FR)**

(74) Mandataire: **Benoit, Monique et al**
**THOMSON-CSF SCPI**
**F-92045 PARIS LA DEFENSE CEDEX 67(FR)**

## Description

La présente invention concerne un détecteur de phase et de fréquence utilisable dans le domaine de la synthèse de fréquence en général et notamment dans les circuits de génération de fréquence des radars.

Dans les synthétiseurs de fréquence en général et dans toutes les boucles d'asservissement de phase l'organe détecteur de l'erreur de phase et de fréquence est un dispositif logique.

Dans l'état actuel de la technique, tous les détecteurs de phase et de fréquence sont du type de ceux connus sous les références MC 4344 (technologie TTL) ou MC 12040 (technologie ECL) de MOTOROLA ou encore 54 HC 4046 (technologie CMOS ou HCMOS) de NATIONAL SEMICONDUCTOR.

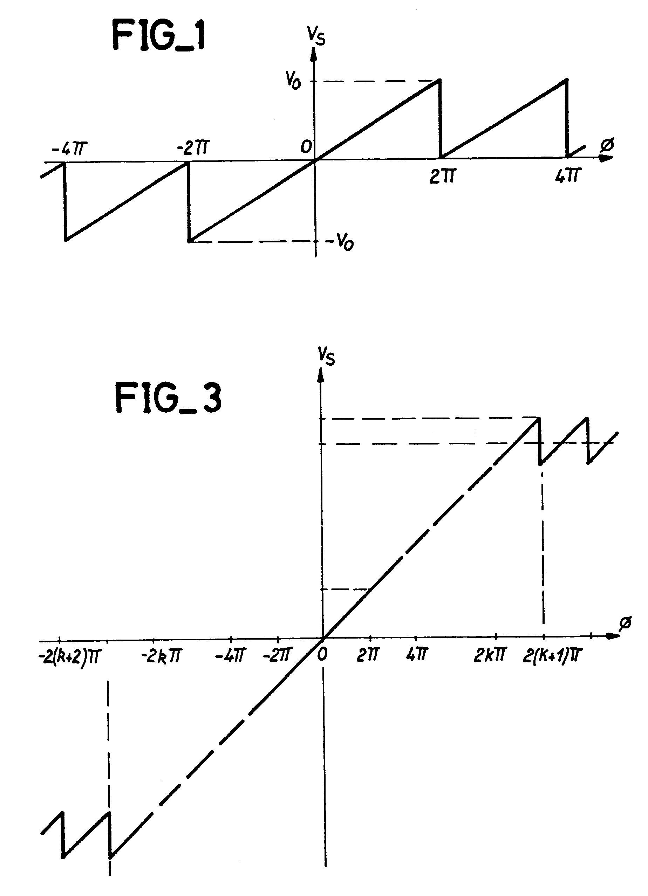

Tous ces détecteurs sont identiques dans le principe et ont le même diagramme de fonctionnement visible sur la figure 1 sur laquelle on a représenté le signal analogique VS = f($\emptyset$) obtenu après décodage et filtrage des signaux logiques de sortie du dispositif logique.

Cette caractéristique de phase VS = f($\emptyset$) est linéaire de - Vo à + Vo lorsque le déphasage relatif des signaux d'entrée R et V du détecteur est compris entre - $2\pi$ et + $2\pi$.

Lorsque le déphasage relatif est supérieur à $|2\pi|$ une boucle d'asservissement de phase utilisant un tel détecteur est décrochée, mais néanmoins le détecteur délivre des dents de scie à une fréquence égale à la différence des fréquences d'entrée FR - FV dont la valeur moyenne filtrée par le filtre de boucle est ± Vo/2 selon le signe de la différence de fréquence. Dans ces conditions la boucle "rallie en fréquence" avec une pente

$$dF/dt = \frac{\omega_n^2}{2}$$

où $\omega_n$ est la pulsation propre de l'asservissement.

Dans une boucle de phase de pulsation propre $\omega_n$ et de pulsation de coupure $\omega_c$ utilisant un tel détecteur, si l'on fait varier la fréquence de référence (R) en échelon de "$\Delta F$" la boucle reste accrochée en phase sur une plage égale à sa bande de capture $\omega_c$, et si $\Delta F > \omega_c$ la boucle "rallie en fréquence" avec une pente égale à

$$\frac{\omega_n^2}{2}$$

jusqu'à une fréquence égale à FR - $\omega_c$ où elle se raccroche en phase. Le temps total de ralliement est donc d'autant plus élevé que $\omega_c$ et $\omega_c$ sont petits ce qui est souvent le cas notamment pour des raisons de pureté spectrale où l'on limite volontairement la bande de boucle $\omega_c$.

Dans le cas où la fréquence d'entrée varie non plus selon un échelon mais linéairement, la pente maxima que la boucle peut suivre en restant accrochée en phase est $dF/dt_{max} = \omega_n^2$.

Pour améliorer les performances de la boucle, on a proposé dans le brevet US-A-4 500 852 de réaliser un détecteur de phase pouvant détecter une différence de phase supérieure à $2\pi$. Ce détecteur est constitué d'un empilage de modules semblables comportant chacun une bascule logique et un circuit de verrouillage. Un signal de référence et un signal d'impulsion à comparer en phase sont appliqués à chaque module avec des retards convenables en fonction de leur rang. Les circuits de verrouillage permettent le transfert ou le blocage des signaux d'entrée vers les bascules. Cependant un tel détecteur est limité en performance, notamment en fréquence, et l'utilisation de retards variables avec la technologie rend cette solution compliquée, assez coûteuse et difficile à mettre en oeuvre.

Le détecteur de phase et de fréquence, objet de la présente invention, permet de délivrer après décodage et filtrage une tension linéaire de la phase différentielle des entrées non pas sur ± $2\pi$ mais sur une plage ± 2 (K + 1) $\pi$, K pouvant être aussi grand que possible sans perte de performance en fréquence pour une technologie donnée.

Avec un tel détecteur, l'erreur de phase n'étant plus limitée à ± $2\pi$ mais à ± 2 (K + 1) $\pi$, la boucle d'asservissement de phase reste accrochée en phase sur un échelon de fréquence (K + 1) $\omega_c$ et si l'échelon de fréquence $\Delta F$ est supérieur à (K + 1) $\omega_c$ la pente de ralliement devient

$$(2K + 1) \frac{\omega_n^2}{2}$$

et cela sans modification de la bande passante de l'asservissement.

En particulier on voit que si l'on désire que la boucle de phase reste accrochée en phase sur un échelon de fréquence ΔF, il suffit que le facteur K ait une valeur

$$k > \frac{\Delta F}{\omega_c} - 1.$$

De la même manière la pente maxima que peut supporter la boucle en restant accrochée en phase est $dF/dt_{max} = (K + 1) \omega_n^2$.

Par ailleurs, dans le cas où la bande passante de la boucle de phase est volontairement faible il est possible d'affecter les sorties des étages de rang K > 1 d'un gain $\alpha$ lui aussi supérieur à 1 ce qui conduit à des performances dynamiques encore accrues.

Le détecteur objet de l'invention permet donc de rendre extrêmement agiles des boucles de phase de faible bande passante sans pénaliser notablement les performances de bruit ou les performances de fréquence d'entrée.

Selon le décodage analogique choisi, un tel détecteur peut s'appliquer à toutes les boucles de phase existantes en multipliant leurs performances dynamiques par un coefficient extrêmement grand.

L'invention a donc pour objet un détecteur de phase et de fréquence ayant les avantages ci-dessus, tel que défini dans les revendications.

D'autres objets et caractéristiques de la présente invention apparaîtront plus clairement à la lecture de la description suivante d'une exemple de réalisation, cette description étant faite en relation avec les dessins ci-annexés dans lesquels, outre la figure 1 relative à l'art antérieur :

- la figure 2 est un schéma d'un exemple de réalisation d'un détecteur de phase et de fréquence suivant l'invention, sans circuit de décodage et de filtrage associé ;
- la figure 3 représente la caractéristique $V_S = f(\emptyset)$ délivrée, après filtrage, par un détecteur de phase et de fréquence suivant l'invention ;
- les figures 4a, 4b, 4c, 4d et 4e sont des chronogrammes illustrant le fonctionnement du schéma de la figure 2 ;
- la figure 5 est également un chronogramme illustrant le fonctionnement du schéma de la figure 2 ;
- la figure 6 représente un circuit de décodage et de filtrage particulier associé au circuit de la figure 2, et permettant à celui-ci d'être utilisé au mieux de ses possibilités ;
- la figure 7a représente un autre circuit de décodage, permettant d'accroître les performances dynamiques d'une boucle à verrouillage de phase utilisant un détecteur suivant l'invention ;
- la figure 7b représente la caractéristique $V_S = f(\emptyset)$ obtenue avec un tel circuit de décodage ;
- la figure 8a est un schéma d'un circuit de détection de verrouillage de boucle de phase, suivant l'art antérieur ;
- la figure 8b est un chronogramme relatif au fonctionnement du schéma de la figure 7a ;
- la figure 9a est un schéma d'un circuit particulier de détection de verrouillage de boucle de phase, associé à un détecteur de phase et de fréquence suivant l'invention ;
- la figure 9b est un chronogramme relatif au fonctionnement du schéma de la figure 8a ;
- la figure 10 montre une variante de réalisation d'un détecteur suivant l'invention.

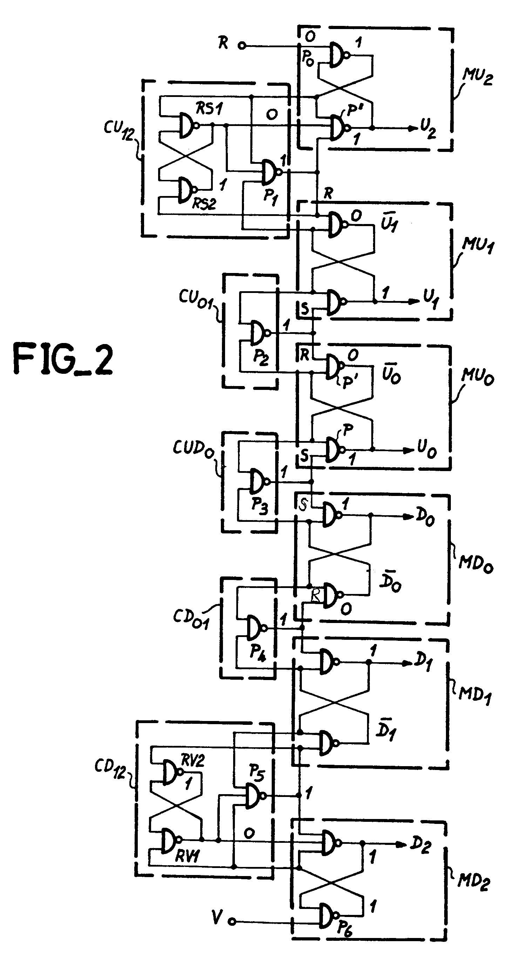

Le détecteur de phase et de fréquence objet de l'invention est représenté sur la figure 2. Ce dispositif permet de délivrer, après décodage et filtrage, une tension $V_S$ linéaire de la phase différentielle des signaux d'entrée sur une plage $\pm 2 (K+1) \pi$, avec à titre d'exemple K = 2.

Ce dispositif est formé par mise en cascade de 2K + 2 (soit ici six) cellules de mémoire $MU_2$, $MU_1$, $MU_0$, $MD_0$, $MD_1$, $MD_2$, reliées deux à deux par 2K + 1 (soit ici cinq) cellules de commande $CU_{12}$, $CU_{01}$, $CUD_0$, $CD_{01}$, $CD_{02}$. Les cellules mémoire d'extrémité $MU_2$ et $MD_2$ reçoivent respectivement les signaux d'entrée numériques R et V.

Ce dispositif se décompose en deux parties symétriques qui jouent un rôle analogue suivant que le signal R est en avance ou en retard de phase par rapport au signal V et qui comportent chacune K + 1 cellules de mémoire et K cellules de commande, respectivement référencées U et D, la cellule de commande centrale $CUD_0$ établissant le lien entre ces deux parties.

Chaque cellule de mémoire consiste en une bascule logique du type "RS" formée de deux portes logiques du type "NON-ET", rebouclées, telles que P et P′ pour la cellule de mémoire $MU_0$, la porte P fournissant un signal logique $U_0$ et la porte P′ un signal complémentaire $\overline{U_0}$.

Les cellules de commande sont de trois types : la cellule de commande centrale ($CUD_0$), les deux cellules de commande d'extrémité ($CU_{12}$ et $CD_{12}$ dans l'exemple choisi correspondant à K = 2) et les cellules de commande intermédiaire (qui sont au nombre de deux dans l'exemple considéré : $CU_{01}$ et $CD_{01}$).

Les cellules de commande intermédiaire consistent en une porte logique du type "NON-ET" qui reçoit d'une part le signal complémentaire de la cellule de mémoire qui la précède (dans le sens de transmission de l'information d'une extrémité du dispositif vers son centre), d'autre part le signal non complémentaire de la cellule de mémoire qui la suit (dans le sens considéré).

Chaque cellule de mémoire étant munie de deux entrées R et S, la sortie de cette porte "NON-ET" est par ailleurs reliée à la fois à l'entrée R de la cellule de mémoire suivante, et à l'entrée S de la cellule de mémoire précédente, ce qui permet, lorsque les conditions sont créées pour un changement d'état de la sortie de cette porte "NON-ET", d'assurer un transfert d'information de la cellule de mémoire précédente vers la cellule de mémoire suivante, tout en remettant la cellule de mémoire précédente à son état initial, celle-ci ne faisant alors que transmettre l'information ayant causé ce changement d'état.

Ainsi la cellule de commande intermédiaire $CU_{01}$ consiste en une porte "NON-ET" $P_2$ qui reçoit d'une part le signal $\overline{U_1}$, d'autre part le signal $U_0$, et dont la sortie est appliquée à la fois à l'entrée R de la cellule de mémoire suivante $MU_0$ et à l'entrée S de la cellule de mémoire précédente $MU_1$.

La cellule de commande centrale $CUD_0$ consiste en une porte "NON-ET" $P_3$ qui reçoit d'une part le signal $\overline{U_0}$, d'autre part le signal $\overline{D_0}$, et dont la sortie est appliquée à la fois à l'entrée S de la cellule de mémoire $MD_0$, et à l'entrée S de la cellule de mémoire $MU_0$. Ainsi lorsque les conditions sont créées pour un changement d'état de cette porte "NON-ET" $P_3$, l'information peut passer d'une cellule de mémoire centrale ($MU_0$ ou $MD_0$) à l'autre, tout en remettant la première à son état initial qui ne fait ainsi que transmettre l'information ayant causé ce changement d'état.

De par le fait que deux signaux complémentaires, tels que $\overline{U_1}$ et $U_0$, sont appliqués à l'entrée des cellules de commande intermédiaire, telles que $CU_{01}$, les conditions pour le transfert de l'information d'une cellule de mémoire vers la suivante, par l'intermédiaire de la cellule de commande intermédiaire qui les relie, sont au nombre d'une seule qui est l'apparition de cette information.

En revanche, de par le fait que les signaux d'entrée de la cellule de commande centrale sont les signaux de même nature $\overline{U_0}$ et $\overline{D_0}$ les conditions pour le transfert de l'information de l'une des cellules de mémoire centrale $MU_0$ ou $MD_0$ (appelée première cellule) vers l'autre (appelée deuxième cellule), c'est-à-dire d'une partie du schéma (transmettant les fronts actifs du signal R) vers l'autre partie (transmettant les fronts actifs du signal V) par l'intermédiaire de la cellule de commande centrale qui les relie, sont au nombre de deux : un changement d'état préalable de la première cellule de mémoire centrale (dû à la transmission à travers la partie correspondante du montage d'un front actif du signal d'entrée correspondant, en avance de phase par rapport à l'autre), suivi d'un changement d'état de la deuxième cellule de mémoire centrale (dû à la transmission à travers la partie correspondante du montage d'un front actif du signal d'entrée correspondant, en retard de phase par rapport à l'autre).

On retrouve alors en sortie de cette première cellule de mémoire centrale des créneaux dont le facteur de forme est proportionnel au déphasage $\Delta\emptyset$ entre les signaux d'entrée R et V.

Ceci n'est vrai qu'à la condition que ce déphasage $\Delta\emptyset$ soit compris entre 0 et $2\pi$.

En effet si ce déphasage est supérieur à $2\pi$, par exemple si les signaux R et V ont des fréquences différentes, le dispositif commence à fonctionner comme précédemment, puis, le déphasage entre ces deux signaux variant progressivement d'un front à l'autre de ces signaux, il arrive un moment où, en supposant par exemple le signal V en avance par rapport au signal R, deux fronts actifs du signal V se succèdent sans qu'intervienne un front actif du signal R. Cela signifie qu'au deuxième front actif du signal V, la cellule de commande centrale ayant eu préalablement une de ses entrées qui a changé d'état au premier front actif du signal V, va se comporter comme une cellule de commande intermédiaire, et que c'est alors la cellule de commande $CD_{01}$ qui va jouer le rôle de cellule de commande centrale. C'est alors non plus la cellule de mémoire $MD_0$ qui délivre des créneaux de facteur de forme proportionnel au déphasage instantané $\Delta\emptyset$ entre les signaux R et V, mais la cellule de mémoire $MD_1$, et ainsi de suite au fur et à mesure que ce déphasage instantané progresse.

En supposant la différence de phase entre les signaux R et V comprise entre $2n\pi$ et $(2n + 1)\,\pi$, la dernière cellule de mémoire à délivrer des créneaux de facteur de forme proportionnel au déphasage instantané $\Delta\emptyset$ entre les signaux R et V consiste dans la cellule $MD_n$ (en supposant toujours le signal V en avance par rapport au signal R). Du fait que les cellules $MD_0$ à $MD_{n-1}$ n'ont pas été remises à leur état initial, les sorties $D_0$ à $D_{n-1}$ sont dans un état logique opposé à celui des sorties $D_{n+1}$ à $D_k$ des cellules $MD_{n+1}$ à $MD_k$, ainsi qu'à celui des sorties $U_0$ à $U_n$ des cellules $MU_0$ à $MU_k$. La sortie $D_n$ de la cellule $MD_n$ délivre, elle, comme on l'a vu, des créneaux représentant le déphasage instantané $\Delta\emptyset$ entre les signaux R et V.

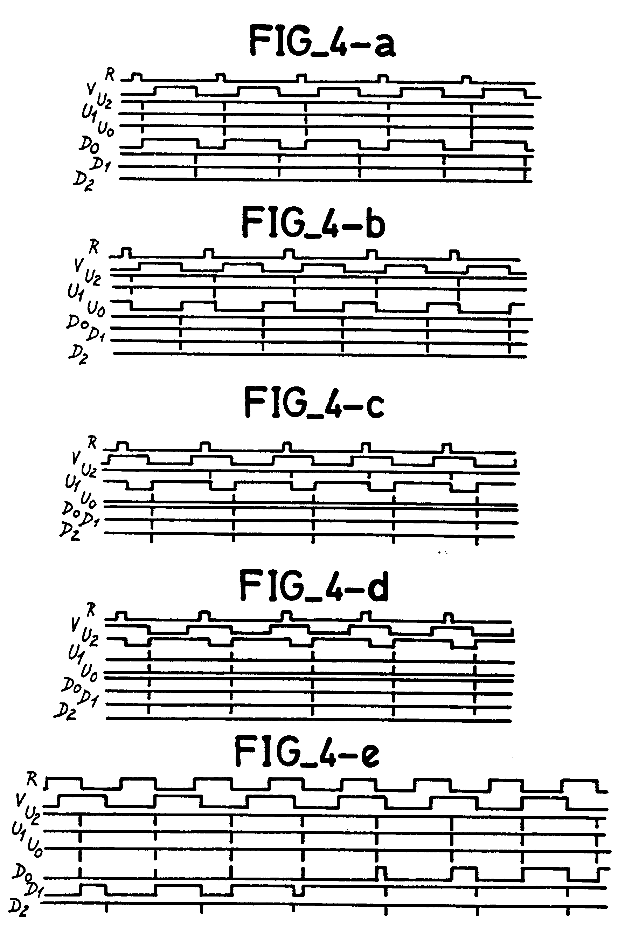

Ainsi, en effectuant une sommation analogique et un filtrage des signaux de sortie de l'ensemble des cellules de mémoire, on obtient une caractéristique $V_S = f(\emptyset)$ telle que représentée sur la figure 3, c'est-à-dire qui présente la particularité d'être linéaire entre $-2(k+1)\pi$ et $+2(k+1)\pi$.

Le fonctionnement du détecteur suivant l'invention représenté sur la figure 1 apparaît sur les chronogrammes des figures 4a, 4b, 4c et 4d correspondant respectivement au cas où $-2\pi < \Delta\phi < 0$, $0 < \Delta\phi < 2\pi$, $2\pi < \Delta\phi < 4\pi$ et $\Delta\phi > 4\pi$, les créneaux de facteur de forme représentatif de $\Delta\phi$ étant alors obtenus respectivement sur la sortie $D_0$, sur la sortie $U_0$, sur la sortie $U_1$ puis sur la sortie $U_2$.

Contrairement à ces chronogrammes qui sont des chronogrammes "instantanés", le chronogramme de la figure 4e montre l'évolution des différents signaux lorsque $\Delta\phi$ varie linéairement de $-4\pi$ à 0.

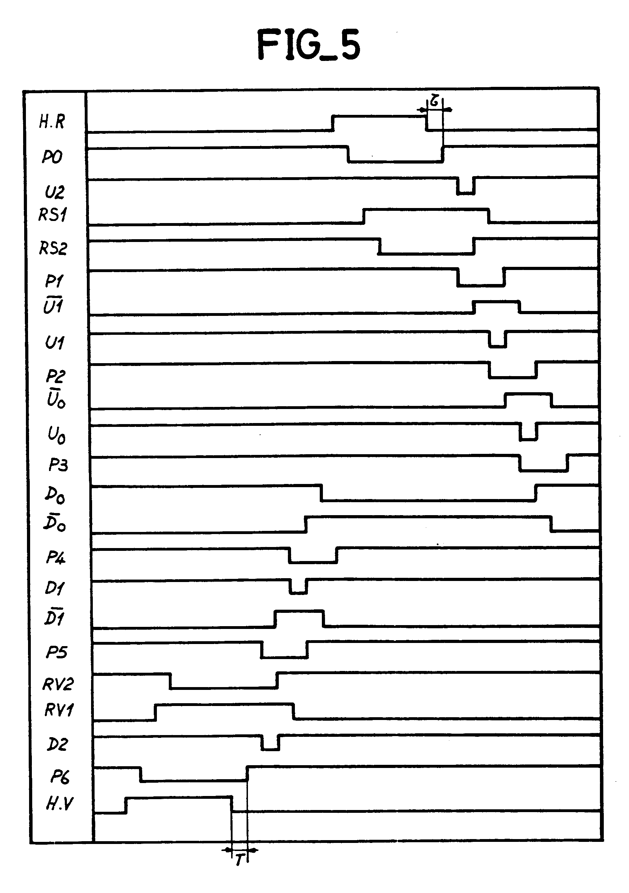

Sur la figure 5 on a représenté un chronogramme "dilaté" ne s'attachant qu'à un créneau des signaux R et V mais faisant intervenir le temps de transit $\tau$ des différentes portes logiques.

Ce chronogramme est également plus complet que les précédents en ce qu'il représente le signal de sortie de chacune des portes logiques du schéma de la figure 1.

Sur le schéma de la figure 2 on a également mentionné les conditions initiales, c'est-à-dire les états logiques existant initialement aux différents points de ce schéma. On notera que les conditions initiales appliquées aux entrées de la porte "NON-ET" $P_3$ (cellule de commande centrale), sont 00, alors que les conditions initiales appliquées aux entrées des autres cellules de commande sont 01, le niveau 0 étant appliqué sur celle des deux entrées qui est susceptible de recevoir l'information dans le sens ou celle-ci se propage, c'est-à-dire sur l'entrée supérieure pour la partie supérieure du schéma et sur l'entrée inférieure pour la partie inférieure du schéma.

On décrit maintenant plus en détail les cellules de commande d'extrémité. Ces cellules de commande d'extrémité ont deux fonctions : une fonction identique à celle des cellules de commande intermédiaires, telle que décrite précédemment, et une fonction de mise en forme des signaux d'entrée logiques R et V.

En effet les signaux R et V peuvent avoir un facteur de forme quelconque. Or les impulsions transmises à travers le dispositif de la figure 2 doivent être très brèves.

Ces cellules de commande d'extrémité permettent de fabriquer de telles impulsions à partir des signaux R et V.

Ainsi la cellule $CU_{12}$ comporte une porte "NON-ET" $P_1$ à trois entrées :
- une première entrée qui reçoit le signal de sortie d'une porte "NON-ET" $P_0$ (située dans la cellule de mémoire d'extrémité $MU_2$) recevant elle-même les signaux $U_2$ et R ;
- une deuxième entrée qui reçoit le signal de sortie d'une bascule "RS" formée de deux portes "NON-ET" $RS_1$ et $RS_2$ et recevant elle même sur une première entrée le signal de sortie de la porte "NON-ET" $P_0$ et sur une deuxième entrée le signal de sortie de la porte "NON-ET" $P_1$ ;
- une troisième entrée qui reçoit le signal $U_1$.

La sortie de cette porte "NON-ET" $P_1$ à trois entrées est reliée à la fois à l'entrée de la cellule de mémoire $MU_1$ et à une première entrée d'une porte "NON-ET" P" située dans la cellule de mémoire d'entrémité $MU_2$ et munie de deux autres entrées, l'une reliée à la sortie de la porte "NON-ET" $P_0$ et l'autre à la sortie de la porte "NON-ET" $RS_1$.

Les cellules d'extrémité comportent ainsi une mémoire auxiliaire ($RS_1/RS_2$ pour l'une des extrémités et $RV_1/RV_2$ pour l'autre) dont la sortie $RS_1$ (ou $RV_1$) remet à "1" la porte logique $P_1$ (ou $P_5$) et à "0" la porte $\overline{U_1}$(ou $\overline{D_1}$), transmettant ainsi un signal d'horloge normalisé de durée $3\tau$ à la cellule $MU_{k-1}$ (ou $MD_{k-1}$) quel que soit le facteur de forme de l'horloge d'entrée R (ou V).

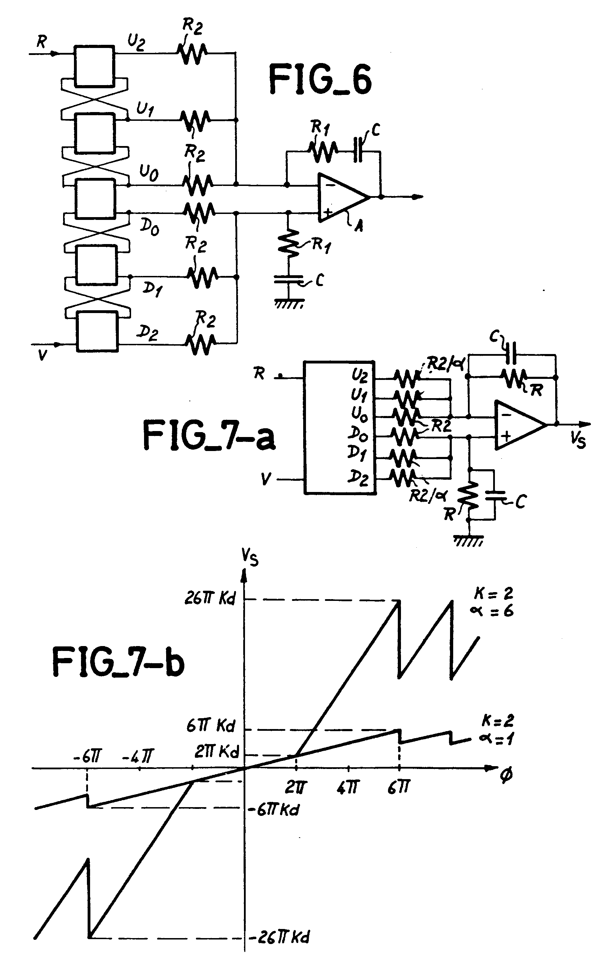

La figure 6 représente le dispositif de la figure 2, associé à un circuit de sommation analogique particulier lui permettant d'être utilisé au mieux de ses performances.

Le dispositif de la figure 2 est représenté très schématiquement par des étages mis en cascade et rebouclés entre eux, chaque étage représentant une cellule de mémoire, de sortie U ou D.

Pour avoir sous forme analogique la valeur du déphasage, il faut effectuer l'opération

$$\Delta = \frac{1}{k_d} \sum_{0}^{k} (U_n - D_n)$$

: où

$$k_d = \frac{v_L}{2\pi},$$

$V_L$ étant l'amplitude des signaux de la logique utilisée pour réaliser le détecteur. Si l'on utilisait un amplificateur différentiel de gain unité pour effectuer la sommation des $U_n$ et $D_n$, la saturation de ce dernier limiterait le nombre d'étages k du détecteur. Pour des valeurs de k élevées, il faudrait alors diminuer le gain, mais la pente de détection diminuerait alors dans les mêmes proportions, ce qui limiterait les performances de la boucle de verrouillage de phase utilisant un tel détecteur, et l'on pourrait également être gêné par le bruit de l'amplificateur.

Suivant l'invention, pour les valeurs de k élevées, la solution consiste à utiliser un amplificateur opérationnel A monté non pas en sommateur mais en intégrateur, ce qui permet à la fois d'effectuer une sommation en courant des sorties $U_n$ et $D_n$ et donc de ne pas être limité par la saturation en tension de l'amplificateur (c'est en effet la somme de courants

$$I_n = \frac{U_n}{R_2}$$

qui vient charger la capacité de l'intégrateur, où $R_2$ désigne la résistance insérée entre la sortie de chacun des étages et l'une des entrées + ou - de l'amplificateur opérationnel A) et de réaliser la fonction de transfert H(P) de la boucle, la sortie de l'amplificateur opérationnel A monté en intégrateur attaquant alors directement la commande de l'oscillateur commandé en tension de cette boucle.

Le circuit de décodage peut aussi être réalisé en affectant un gain $\alpha > 1$ aux étages de rang $k > 1$, en branchant sur ces derniers des résistances de valeur

$$\frac{R_2}{\alpha},$$

comme représenté sur la figure 7a. La caractéristique de sortie correspondante $U_S = f(\emptyset)$ représentée sur la figure 7b montre que la pente $K_d$ est inchangée dans l'intervalle $- 2\pi$, $+ 2\pi$ et qu'elle est multipliée par $\alpha$ pour $|\emptyset| > 2\pi$. Les performances dynamiques d'une boucle de phase équipée d'un tel détecteur sont grandement améliorées, comme le montre le tableau ci-dessous qui permet de comparer les performances dynamiques d'une boucle de phase équipée d'un détecteur de phase et de fréquence suivant l'art antérieur, fonctionnant dans l'intervalle $\pm 2\pi$ (D.P.F. $\pm 2\pi$) aux performances dynamiques d'une boucle de phase équipée d'un détecteur de phase et de fréquence suivant l'invention, fonctionnant dans l'intervalle $\pm 2 (K+1) \pi$, et affecté de plus d'un coefficient $\alpha$.

**Performances dynamiques comparées d'une boucle de phase de pulsation propre $\omega_n$**

| | D.P.F $\pm 2\pi$ | D.P.F $\pm 2(K-1)\pi$ |
|---|---|---|
| bande de capture | $\omega_c$ | $(1+K\alpha)\,\omega_c$ |
| Rampe de fréquence | $\omega_n^2$ | $(1+K\alpha)\,\omega_n^2$ |
| Ralliement en fréquence | $\omega_{n/2}^2$ | $[1+\alpha(K-1/2)]\,\omega_n^2$ |

La présente invention a également pour objet un circuit de détection de verrouillage d'une boucle de phase incorporant un détecteur de phase et de fréquence suivant l'invention.

Il peut en effet être nécessaire de connaître l'instant d'accrochage d'une telle boucle, par exemple en vue de commander un autre dispositif à cet instant précis.

6

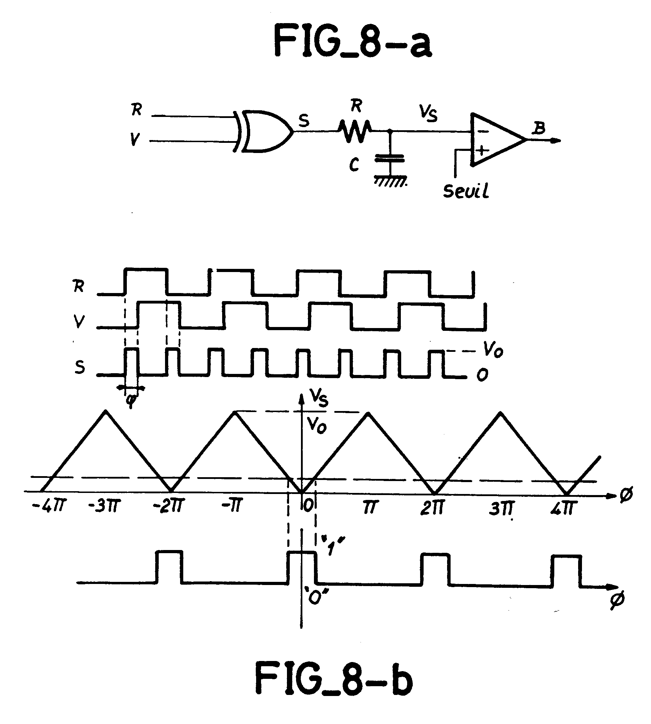

Pour cela, il est connu, selon l'art antérieur et comme montré sur la figure 8a, d'effectuer un "OU-exclusif" entre les signaux R et V, ce qui donne un signal S tel que représenté sur le chronogramme de la figure 8b, puis de filtrer le signal S ainsi obtenu, ce qui donne un signal $V_S(\emptyset)$ tel que représenté également sur la figure 8b, puis d'effectuer une comparaison avec un seuil inférieur à

$$\frac{V_0}{2},$$

ce qui donne un signal B tel que représenté aussi sur la figure 8b.

On voit sur ces figures qu'avec un tel circuit, il y a ambiguïté de connaissance de l'instant d'accrochage de la boucle (c'est-à-dire de l'instant où $\emptyset$ devient égal à 0) car le signal $V_S(\emptyset)$ s'annule pour toutes les valeurs de $\emptyset$ multiples de $2\pi$.

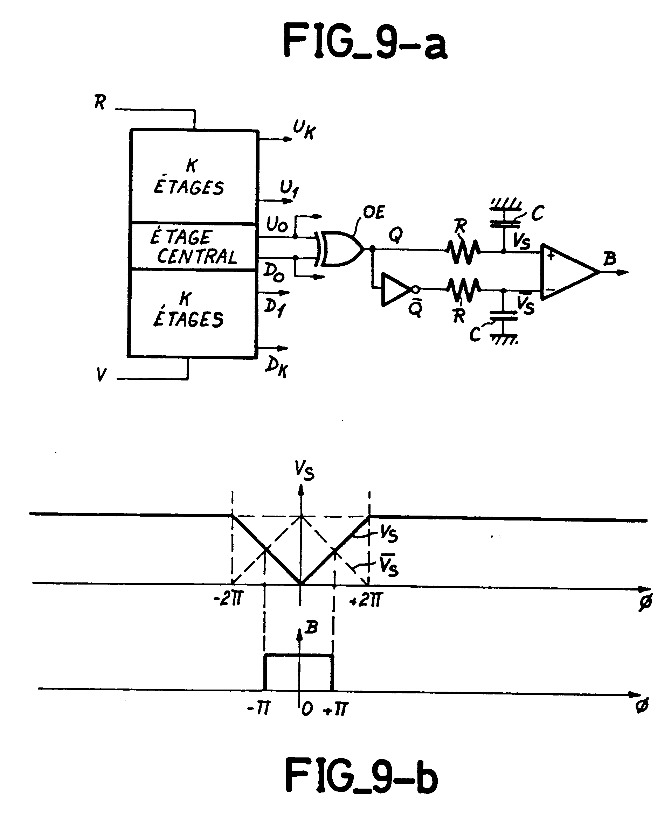

Comme représenté sur la figure 9a avec un circuit "OU-exclusif" OE connecté aux sorties de même nature $U_0$ et $D_0$ des deux cellules de mémoire centrale $MU_0$ et $MD_0$ du détecteur de phase et de fréquence suivant l'invention, une telle ambiguïté est supprimée puisque pour $|\emptyset| > 2\pi$, ces deux sorties sont par nature dans des états logiques opposés. Ceci apparaît sur la figure 9b représentant les signaux $V_S(\emptyset)$ et B $(\emptyset)$ obtenus respectivement en sortie du circuit de filtrage R-C destiné alors à filtrer les impulsions brèves de durée $\tau$ des sorties $U_0$ et $D_0$, et en sortie du comparateur. Le signal de seuil est par ailleurs constitué par filtrage du signal $\overline{Q}$ égal au complément du signal Q de sortie du "OU-exclusif".

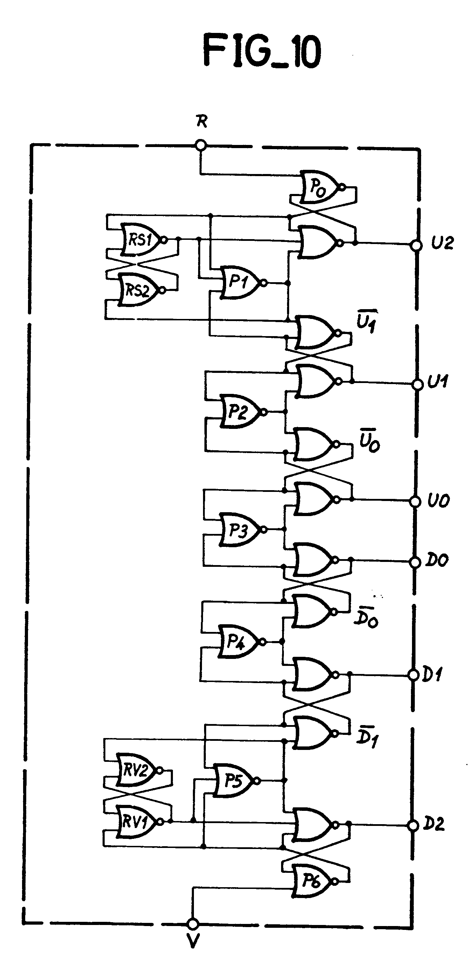

La description et le fonctionnement précédents se rapportent au schéma de la figure 2 dans lequel le circuit objet de l'invention est réalisé à l'aide de portes "NON-ET". Le même schéma peut être réalisé à l'aide de portes "NON-OU", comme représenté sur la figure 10. Le principe est le même ; la seule différence réside dans le fait que le dispositif est sensible aux fronts montants (et non plus descendants) des horloges R et V, et dans le fait que les sorties D ou U sont les compléments des mêmes sorties dans le schéma précédent utilisant des portes "NON-ET".

## Revendications

1. Détecteur de phase et de fréquence, recevant deux signaux d'entrée logiques R et V et comportant un empilage de cellules du type bascules logiques "RS" et des moyens de commande à portes logiques desdites cellules, caractérisé en ce que, pour délivrer une tension variant linéairement en fonction de la phase différentielle desdits signaux d'entrée sur une plage de $\pm 2(K+1)\pi$, ledit détecteur comprend :
   - $2k+2$ cellules mémoires du types bascules logiques "RS" ($MU_k$ à $MU_0$ ; $MD_0$ à $MD_k$) mises en cascade ;
   - $2k+1$ cellules de commande ($CU_{k-1k}$ à $CU_{01}$, $CUD_0$, $CD_{01}$ à $CD_{k-1,k}$) pour réaliser cette mise en cascade en reliant deux à deux lesdites cellules mémoires, chaque cellule de commande comportant une porte logique (P1 à P5) ayant, pour la cellule de commande centrale (P3), une première et une seconde entrées reliées respectivement aux sorties de même nature ($\overline{U}_0$, $\overline{D}_0$) des cellules mémoires centrales ($MU_0$, $MD_0$) qu'elle relie et une sortie reliée aux entrées de même nature (S) de ces cellules mémoires et, pour chacune des autres cellules de commande (P1, P2, P4, P5), une première et une seconde entrées reliées respectivement à une sortie de type complémentaire ($\overline{U}_2$, $U_1$ ; $\overline{U}_1$, $\overline{U}_0$ ; $D_0$, $\overline{D}_1$ ; $D_1$, $\overline{D}_2$) des deux cellules mémoires qu'elle relie et une sortie reliée à une entrée, de nature différente (R, S), de chacune de ces deux cellules mémoires, lesdits signaux d'entrée (R, V) étant respectivement appliqués à l'entrée libre desdites cellules mémoires d'extrémité ($MU_2$, $MD_2$) ;
   - des moyens de transformation de signal à portes logiques (RS1, RS2 ; RV1, RV2) associés à chacune des cellules de commande d'extrémité ($CU_{12}$ ; $CD_{12}$) et aux cellules mémoires d'extrémité associées ($MU_2$ ; $MD_2$) pour transformer les créneaux des signaux d'entrée (R, V) en impulsions brèves ; et
   - des moyens de sommation (A, $R_2$, $R_1$, C ; $R_{2/\alpha}$, C, R) des signaux présents sur les sorties de même type de toutes les cellules mémoires pour fournir ladite tension variant linéairement ; lesdites cellules de commande assurant, d'une part, le transfert de l'information contenue dans les changements d'état des signaux d'entrée R et V, depuis les cellules mémoires d'extrémité $MU_k$, $MD_k$ auxquelles ils sont respectivement appliqués, jusqu'à une cellule mémoire $MU_n$ ou $MD_n$, où $0 \leq n \leq k$, suivant que le signal R est en avance ou en retard par rapport au signal V, celle-ci fournissant alors des créneaux dont le facteur de forme est proportionnel au déphasage instantané $\Delta\emptyset$ entre les signaux R et V lorsque $2n\pi < |\Delta\emptyset| < (2n+1)\pi$, et, d'autre part, la fourniture

7

auxdites cellules mémoires de signaux de maintien des cellules $MU_{n+1}$ à $MU_k$ et $MD_0$ à $MD_k$ dans leur état logique initial et des cellules $MU_0$ à $MU_{n-1}$ dans un état logique opposé, ou bien de maintien des cellules mémoires $MD_{n+1}$ à $MD_k$ et $MU_0$ à $MU_k$ dans leur état logique initial et des cellules $MD_0$ à $MD_{n-1}$ dans un état logique opposé, suivant que le signal R est en avance ou en retard par rapport au signal V.

2. Détecteur selon la revendication 1, caractérisé en ce que les cellules de commande comportent des portes logiques du type "NON-ET".

3. Détecteur suivant la revendication 1, caractérisé en ce que les cellules de commande comportent des portes logiques du type "NON-OU".

4. Détecteur selon l'une quelconque des revendications 1 à 3, caractérisé en ce que lesdits moyens de transformation comprennent deux portes logiques (RS1, RS2 ; RV1, RV2) interconnectées en bascule de type "RS" dont les entrées sont connectées respectivement à la sortie complémentée de la cellule mémoire d'extrémité associée($\overline{U}_2$ ; $\overline{D}_2$) et à la sortie de la porte logique ($P_1$ ; $P_5$) de la cellule de commande d'extrémité associée et dont la sortie est reliée respectivement à une entrée supplémentaire de ladite porte logique de la cellule de commande associée et à une entrée supplémentaire de la cellule mémoire d'extrémité associée, de même nature que l'entrée de cette cellule reliée à la sortie de ladite porte logique.

5. Détecteur selon l'une quelconque des revendications 1 à 4, caractérisé en ce que lesdits moyens de sommation sont prévus pour effectuer une sommation en courant des signaux de sortie des diverses cellules mémoires.

6. Détecteur selon l'une quelconque des revendications 1 à 4, caractérisé en ce que lesdits moyens de sommation sont prévus pour effectuer une sommation en courant des signaux de sortie des diverses cellules mémoires avec une pondération ($\alpha$) pour les cellules de rang $n > 0$.

7. Détecteur selon l'une quelconque des revendications 5 ou 6, caractérisé en ce que lesdits moyens de sommation comprennent un amplificateur opérationnel (A) monté en intégrateur.

8. Boucle à verrouillage de phase utilisant un détecteur de phase et de fréquence suivant l'une des revendications 1 à 7.

9. Boucle à verrouillage de phase utilisant un détecteur de phase et de fréquence suivant l'une des revendications 1 à 7, et comportant un circuit de détection de verrouillage de cette boucle, caractérisé en ce que ce dernier consiste en un circuit OU-exclusif connecté aux sorties ($U_0$-$D_0$) des cellules mémoires centrales.

**Claims**

1. A phase and frequency detector receiving two logic input signals R and V and comprising a stack of cells of the logical RS flip-flop type and control means including logic gates for controlling said cells, characterized in that, in order to deliver a voltage which varies linearly with the differential phase of said input signals over a range of $\pm 2(k+1).\pi$, said detector comprises:
   - $2k+2$ cascade-connected memory cells of the logic RS type ($MU_k$ to $MU_0$; $MD_0$ to $MD_k$);
   - $2k+1$ control cells ($CU_{k-1,k}$ to $CU_{01}$, $CUD_0$, $CD_{01}$ to $CD_{k-1,k}$) in order to establish this cascade by pairwise connecting said memory cells, each control cell comprising a logic gate (P1 to P5), the logic gate (P3) of the central control cell having a first and a second input respectively connected to the outputs of the same kind ($\overline{U}_0$, $\overline{D}_0$) of the central memory cells ($MU_0$, $MD_0$) which it connects, and an output connected to the inputs of the same type (S) of these memory cells, and the logic gates of the other control cells (P1, P2, P4, P5) having a first and a second input connected respectively to an output of the complementary type ($\overline{U}_2$, $U_1$,; $\overline{U}_1$, $U_0$; $D_0$, $\overline{D}_1$; $D_1$, $\overline{D}_2$) of the two memory cells which it connects, and an output connected to an input of different kind (R, S) of each of these two memory cells, said input signals (R, V) being respectively applied to the free input of said terminal memory cells ($MU_2$, $MD_2$);
   - signal converting means including logic gates (RS1, RS2; RV1, RV2) associated to each of the

terminal control cells ($CU_{12}$; $CD_{12}$) and to the associated terminal memory cells ($MU_2$; $MD_2$) in order to convert the rectangular input signal pulses (R, V) into short pulses,

- means (A, $R_2$, $R_1$, C; $R_2/\alpha$, C, R) for summing the signals available at the outputs of the same type of all the memory cells in order to supply said linearly varying voltage; said control cells ensuring, on the one hand, the transfer of the information contained in the change of state of the input signals R and V from the terminal memory cells ($MU_k$, $MD_k$) to which they are respectively applied, down to a memory cell $MU_n$ or $MD_n$ wherein $0 \leq n \leq k$ depending on whether the signal R precedes or follows the signal V, said memory cell then supplying rectangular pulses whose shape factor is proportional to the instantaneous phase shift $\Delta\emptyset$ between the signals R and V if $2n\pi < |\Delta\emptyset| < (2n+1)\pi$, and ensuring, on the other hand, the supply of signals to said memory cells for holding the cells $MU_{n+1}$ to $MU_k$ and $MD_0$ to $MD_k$ in their initial logic state and the cells $MU_0$ to $MU_{n-1}$ in an opposite logic state, or else for holding the memory cells $MD_{n+1}$ to $MD_k$ and $MU_0$ to $MU_k$ in their initial logic state and the cells $MD_0$ to $MD_{n-1}$ in an opposite logic state depending on whether the signal R precedes or follows the signal V.

2. A detector according to claim 1, characterized in that the control cells comprise logic gates of the NAND type.

3. A detector according to claim 1, characterized in that the control cells comprise logic gates of the NOR type.

4. A detector according to any one of claims 1 to 3, characterized in that the conversion means comprise two logic gates (RS1, RS2; RV1, RV2) which are mounted in a RS flip-flop circuit whose inputs are respectively connected to the inverted output of the associated terminal memory cell ($\overline{U}_2$; $\overline{D}_2$) and to the output of the logic gate ($P_1$; $P_5$) of the associated terminal control cell, and whose output is respectively connected to an additional input of the logic gate of the associated control cell and to an additional input of the associated terminal memory cell of the same kind as the input of this cell which is connected to the output of said logic gate.

5. A detector according to any one of claims 1 to 4, characterized in that said summing means are conceived to sum up the output signal currents of the different memory cells.

6. A detector according to any one of claims 1 to 4, characterized in that saids summing means are conceived to sum up the output signal currents of the different memory cells, thereby applying a weighting factor ($\alpha$) for the cells of rank n>0.

7. A detector according to any one of claims 5 to 6, characterized in that said summing means comprise an operational amplifier (A) in an integrator configuration.

8. A phase-locked loop using a phase and frequency detector according to one of claims 1 to 7.

9. A phase-locked loop using a phase and frequency detector according to one of claims 1 to 7 and comprising a circuit for detecting the locking of the loop, characterized in that the latter circuit consists in an exclusive OR circuit connected to the outputs ($U_0$-$D_0$) of the central memory cells.

**Patentansprüche**

1. Phasen- und Frequenzdetektor, dem zwei logische Eingangssignale R und V zugeführt werden und der eine Reihe von Zellen vom Typ logische RS-Kippstufen und logische Torschaltungsmittel zur Steuerung dieser Zellen aufweist, dadurch gekennzeichnet, daß der Detektor zur Ausgabe einer abhängig von der Differentialphase der Eingangssignale im Bereiche von $\pm 2(k+1).\pi$ linear veränderlichen Spannung aufweist:
   - $2k+2$ Speicherzellen vom Typ logische RS-Kippstufen ($MU_k$ bis $MU_0$; $MD_0$ bis $MD_k$), die in Kaskade geschaltet sind;
   - $2k+1$ Steuerzellen ($CU_{k-1,k}$ bis $CU_{01}$, $CUD_0$, $CD_{01}$ bis $CD_{k-1,k}$) zur Herstellung dieser Kaskade, indem die Speicherzellen paarweise verbunden werden, wobei jede Steuerzelle ein logisches Tor (P1 bis P5) aufweist, das für die zentrale Steuerzelle (P3) einen ersten und einen zweiten Eingang besitzt, die an die Ausgänge gleicher Art ($\overline{U}_0$, $\overline{D}_0$) der sie anschließenden zentralen Speicherzel-

len ($MU_0$, $MD_0$) angeschlossen sind, und einen Ausgang, der an die Eingänge (S) gleicher Art dieser Speicherzellen angeschlossen ist, und für jede der anderen Steuerzellen (P1, P2, P4, P5) einen ersten und einen zweiten Eingang besitzt, die an einen Ausgang komplementären Typs ($\overline{U}_2$, $U_1$; $\overline{U}_1$, $U_0$; $D_0$, $\overline{D}_1$; $D_1$, $\overline{D}_2$) der beiden sie anschließenden Speicherzellen angeschlossen sind, und einen Ausgang, der an einen Eingang anderer Art (R, S) jeder dieser Speicherzellen angeschlossen ist, wobei die Eingangssignale (R, V) an den freien Eingang der endseitigen Speicherzellen ($MU_2$, $MD_2$) angeschlossen sind;

- Signaltransformationsmittel vom Typ logische Tore (RS1, RS2; RV1, RV2), die jeder der endseitigen Steuerzellen ($CU_{12}$; $CD_{12}$) und den entsprechenden endseitigen Speicherzellen ($MU_2$; $MD_2$) zugeordnet sind, um die rechteckigen Eingangssignale (R, V) in kurze Impulse umzuwandeln;

- und Mittel (A, $R_2$, $R_1$, C; $R_2/\alpha$, C, R) zum Summieren der an den Ausgängen gleichen Typs aller Speicherzellen vorliegenden Signale, um die linear veränderliche Spannung zu liefern, wobei die Steuerzellen einerseits die Übertragung der in den Zustandswechseln der Eingangssignale R und V enthaltenen Informationen ausgehend von je einer der endseitigen Speicherzellen ($MU_k$, $MD_k$), an die sie angelegt sind, bis zu einer Speicherzelle $MU_n$ oder $MD_n$ bewirken, wobei $0 \leq n \leq k$ gilt, je nachdem, ob das Signal R bezüglich des Signals V voreilt oder nacheilt, wobei diese Speicherzelle dann Rechteckimpulse liefert, deren Formfaktor proportional zur augenblicklichen Phasenverschiebung $\Delta\emptyset$ zwischen den Signalen R und V ist, wenn $2n\pi < |\Delta\emptyset| < (2n+1)\pi$, während die Steuerzellen andererseits die Lieferung von Signalen an die Speicherzellen zum Halten der Zellen $MU_{n+1}$ bis $MU_k$ und $MD_0$ bis $MD_k$ in ihrem ursprünglichen logischen Zustand und der Zellen $MU_0$ bis $MU_{n-1}$ in einem inversen logischen Zustand oder aber zum Halten der Speicherzellen $MD_{n+1}$ bis $MD_k$ und $MU_0$ bis $MU_k$ in ihrem ursprünglichen logischen Zustand und der Zellen $MD_0$ bis $MD_{n-1}$ in einem inversen logischen Zustand bewirken, je nachdem, ob das Signal R bezüglich des Signals V voreilt oder nacheilt.

2. Detektor nach Anspruch 1, dadurch gekennzeichnet, daß die Steuerzellen logische Tore vom NICHT-UND-Typ enthalten.

3. Detektor nach Anspruch 1, dadurch gekennzeichnet, daß die Steuerzellen logische Tore vom NICHT-ODER Typ enthalten.

4. Detektor nach einem beliebigen der Ansprüche 1 bis 3, dadurch gekennzeichnet, daß die Transformationsmittel zwei logische Tore (RS1, RS2; RV1, RV2) aufweisen, die in Form einer RS-Kippstufe zusammengeschaltet sind, deren Eingänge an den Komplementärausgang der zugeordneten endseitigen Speicherzelle ($\overline{U}_2$; $\overline{D}_2$) bzw. an den Ausgang des logischen Tors ($P_1$; $P_5$) der zugeordneten endseitigen Steuerzelle angeschlossen ist und deren Ausgang an einen zusätzlichen Eingang des logischen Tors der zugeordneten Steuerzelle bzw. an einen zusätzlichen Eingang der zugeordneten endseitigen Speicherzelle derselben Art angeschlossen ist wie der Eingang dieser Zelle, der an den Ausgang des logischen Tors angeschlossen ist.

5. Detektor nach einem beliebigen der Ansprüche 1 bis 4, dadurch gekennzeichnet, daß die Summiermittel zum Summieren der Ströme der Ausgangssignale der verschiedenen Speicherzellen ausgebildet sind.

6. Detektor nach einem beliebigen der Ansprüche 1 bis 4, dadurch gekennzeichnet, daß die Summiermittel zum Summieren der Ausgangssignalströme der verschiedenen Speicherzellen mit einem Gewichtungsfaktor ($\alpha$) für die Zellen des Rangs $n > 0$ ausgebildet sind.

7. Detektor nach einem beliebigen der Ansprüche 5 oder 6, dadurch gekennzeichnet, daß die Summiermittel einen Operationsverstärker (A) aufweisen, der als Integrator geschaltet ist.

8. Phasenverriegelungsschleife, die einen Phasen- und Frequenzdetektor nach einem der Ansprüche 1 bis 7 verwendet.

9. Phasenverriegelungsschleife, die einen Phasen- und Frequenzdetektor nach einem der Ansprüche 1 bis 7 verwendet und einen Schaltkreis zur Erfassung der Schleifenverriegelung enthält, dadurch gekennzeichnet, daß dieser Schaltkreis von einem Exklusiv-ODER-Kreis gebildet wird, der an die Ausgänge ($U_0$-$D_0$) der zentralen Speicherzellen angeschlossen ist.

FIG_1

FIG_3

# FIG_2

# FIG_4-a

# FIG_4-b

# FIG_4-c

# FIG_4-d

# FIG_4-e

# FIG_5

FIG_6

FIG_7-a

FIG_7-b

# FIG_8-a

# FIG_8-b

# FIG_9-a

# FIG_9-b

# FIG_10